(19) Europäisches Patentamt
European Patent Office
Office européen des brevets

(11) Numéro de publication : **0 477 086 A1**

(12) **DEMANDE DE BREVET EUROPEEN**

(21) Numéro de dépôt : **91402465.8**

(22) Date de dépôt : **17.09.91**

(51) Int. Cl.$^5$ : **G02F 2/02,** H01S 3/025, H01L 31/153

(30) Priorité : **21.09.90 FR 9011678**

(43) Date de publication de la demande :
**25.03.92 Bulletin 92/13**

(84) Etats contractants désignés :
**DE GB IT**

(71) Demandeur : **THOMSON-CSF**
**51, Esplanade du Général de Gaulle**
**F-92800 Puteaux (FR)**

(72) Inventeur : **Pocholle, Jean-Paul**
**THOMSON-CSF, SCPI, Cédex 67**
**F-92045 Paris la Défense (FR)**
Inventeur : **Papuchon, Michel**
**THOMSON-CSF, SCPI, Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Convertisseur de fréquences lumineuses.**

(57) Structure prévoyant une intégration monolithique d'un détecteur optique (4, 10, 5,6) avec un émetteur optique (7, 9, 12) travaillant dans le domaine du visible ou du proche IR.

Ce type de source permet de transposer une image perçue appartenant à un domaine de longueur d'onde vers un autre domaine de longueur d'onde et cela avec un bon rendement (couplage photons/électrons).

Applications : Imagerie, traitement du signal.

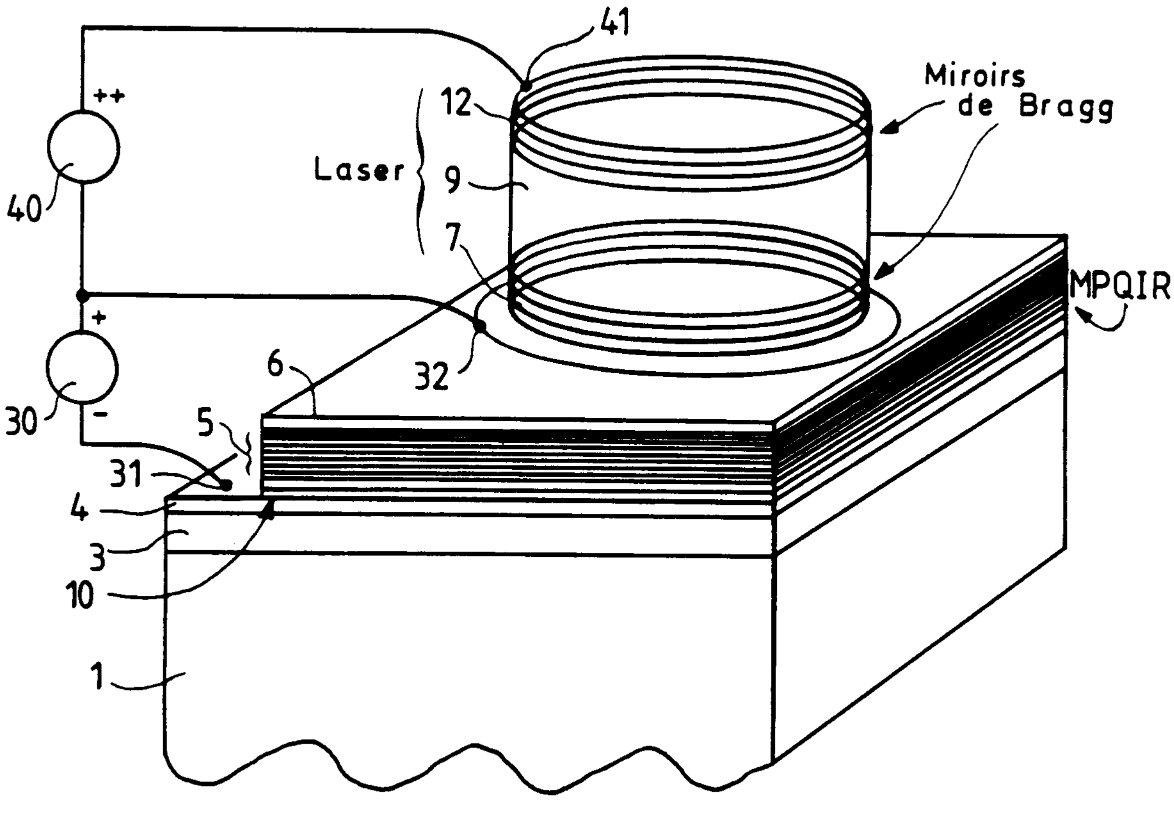


FIG.2

EP 0 477 086 A1

L'invention concerne un convertisseur de fréquences lumineuses et plus particulièrement un convertisseur optique -électrique-optique transposant une onde détectée en une onde située dans un autre domaine spectral.

Avec le développement de composés à base de puits quantiques dont on peut contrôler l'existence de bandes d'absorption, une nouvelle classe de détecteur émerge. Elle repose sur une maîtrise de l'ingénierie quantique dans les matériaux semiconducteurs de la classe III-V

Parallèlement, des matériaux nouveaux émergent dans le domaine du visible. Les composés employés peuvent être déposés sur des substrats identiques à ceux utilisés pour réaliser la fonction absorption et détection à différentes longueurs d'ondes. Cette compatibilité rend ainsi le couplage détection/émission naturel.

L'invention concerne donc un convertisseur de fréquences lumineuses caractérisé en ce qu'il comporte :

– un photodétecteur à multipuits quantiques comportant un ensemble de couches constituant les multipuits quantiques comprenant une première et une deuxième faces, un rayonnement lumineux à convertir étant reçue sur la première face et détecté par le photodétecteur ;
– un dispositif laser disposé sur la deuxième face du photodétecteur à multipuits quantiques de façon à être connecté électriquement en série avec le photodétecteur.

Les différents objets et caractéristiques de l'invention apparaîtront plus clairement dans la description qui va suivre faite à titre d'exemple et dans les figures annexées qui représentent :

– la figure 1, un exemple de réalisation de l'invention ;
– la figure 2, un exemple de réalisation plus détaillé du dispositif de l'invention ;
– la figure 3, un exemple de montage électrique du dispositif de l'invention

En se reportant à la figure 1, on va donc tout d'abord décrire un exemple de réalisation d'une structure selon l'invention

Un substrat 1 en matériau GaAs semi-isolant comporte une face 10.

Un réseau 2 permettant d'optimiser le couplage de l'onde de rayonnement incidente avec le dipôle de la transition intrabande entre niveaux d'énergie dans la bande de conduction.

Ce réseau est réalisé à partir des opérations classiques de polissage mécano-chimique, de résinage, de masquage et d'attaque chimique sélective ou par faisceau d'ions. Ce réseau est réalisé lorsque la croissance et les opérations de technologie ont été réalisées.

Sur la face 20 du substrat opposée à la face 10 et orientée selon l'orientation cristallographique ( 100 ) du substrat, est déposée, une couche 1' de GaAs de 50nm, puis une autre couche 4 en GaAs dopée n+ (0,5μm). Sur cette couche 3 on dépose une couche 4 de AlAs (n+) qui permet avec la couche précédente de faire et de prendre un contact électrique commun.

Ensuite un ensemble de multi-puits quantiques 5 est déposé. L'épaisseur des matériaux de puits ainsi que la composition des matériaux de barrières sont choisis de façon à obtenir une structure résonnante dans le domaine spectrale à détecter. On peut employer un ensemble multi-puits quantiques ou un super réseau. Une partie des matériaux constituant les puits est dopée de façon à peupler le premier niveau pouvant être occupé par les électrons dans la bande de conduction, chaque puits quantique élémentaire de l'ensemble 5 peut être conçu pour présenter une absorption intra-bande à une longueur d'onde déterminée.

Par exemple :

- la structure élémentaire ou période du multi-puits quantique peut être définie pour qu'elle présente une absorption intrabande au voisinage de 10,6μm par exemple. Dans ce cas, la composition et les épaisseurs de couches peuvent être les suivantes :

– largeur du puits : 3 nm
– largeur de barrière : 14 nm
– composition du puits : GaAs
– composition de la barriere : $Ga_{.75}Al_{.25}As$
– dopage de type delta du puits par du silicium.

Le nombre de multipuits détermine l'absorption du système à la longueur d'onde à détecter.

Sur cette structure est ensuite déposée une couche 6 en GaAs dopé n+. Elle a pour fonction de permettre l'application d'un champ à la structure 5 résonnante dans le domaine de longueur d'onde à détecter.

L'épaisseur de cette couche 6 est par exemple de 1 μm.

Sur la couche 6 est réalisé un miroir de Bragg 7. Ce miroir ce compose d'une alternance de couches de compositions différentes fournissant des indices de réfraction différents. Les compositions sont choisies de manière à ce que le maximum de réflectivité soit centré sur la longueur d'onde d'émission du matériau actif laser. De plus, les matériaux sont choisis de manière à ce qu'ils présentent une faible absorption à la longueur d'onde d'émission laser.

Le miroir de Bragg 7 se compose par exemple d'une vingtaine de couches de $Ga_{1-x}Al_xAs$ alternées avec une vingtaine de couches de AlAs.

La valeur de x est par exemple 0,8.

Sur le miroir de Bragg est réalisé un ensemble de couches 9 constituant des multipuits quantiques. Par exemple, on a 3 à 10 multipuits quantiques(largeur des puits = 10 nm), (largeur des barrières = 10 nm) localisés dans un matériau GaA1As. Chaque couche de composition ternaire 8 et 11 située de part et d'autre des multi-puits quantiques 9 est dopée n+ et p+. Ensuite, on réalise un miroir de Bragg 12 dopé p+.

Le nombre d'alternances de couches du miroir de Bragg 12 est plus faible que celui constituant le miroir de Bragg 7 de manière à optimiser la fuite sur le miroir de sortie 12 (optimisation du coefficient de surtension de la cavité).

La figure 2 représente un exemple de réalisation détaillé de l'invention selon lequel les miroirs de Bragg 7 et 12 et la partie laser d'émission 9 ont été gravés de façon à constituer un plot sur le détecteur à multipuits quantiques 5.

Le procédé de réalisation du dispositif consistera à réaliser sur le substrat 1 la succession des différentes couches décrites en relation avec la figure 1. Ensuite, la distribution spatiale bidimensionnelle des détecteurs est réalisée par attaque chimique sélective de l'ensemble des couches. On obtient ainsi un ensemble de structures MESA. La couche 4 en A1As (n+) voisine du substrat représente une couche tampon ou d'arrêt vis-à-vis de cette attaque chimique. Une seconde opération d'attaque chimique permet de définir le motif de la diode laser (confinement latéral). La réalisation de ces pixels (délimitation des zônes) peut également être envisagée en utilisant une attaque par faisceau d'ions. Ensuite par l'emploi de techniques de masquage et d'isolation par dépôt de silice ou d'alumine on réalise les contacts ohmiques avec définition du motif d'électrodes.

Pour le fonctionnement d'un tel dispositif, on connecte un premier générateur de tension 30 à des contacts ohmiques 31 et 32 situés sur la couche 4 et sur la couche 11 et un deuxième générateur de tension 40 au contact ohmique 32 et à un contact ohmique 41 situé sur le miroir de Bragg 12.

Le schéma électrique du dispositif est tel que représenté en figure 3. Le détecteur ($D_d$) et le laser d'emission ($D_L$), étant connectés en série et en opposition.

La commande de la partie photodétecteur Dd est donc réalisée en appliquant une tension sur la zone nin de la structure. La couche 4 dopée n+ située au voisinage du substrat représente la partie commune électrique (-). La seconde couche 6 dopée n+ déposée après la structure 5 permet d'appliquer une tension à la structure de détection.

La partie détection se comporte comme une résistance variable mais également comme un générateur de courant. Cette résistance et le photocourant généré dépendent de l'intensité optique incidente. Ce photodétecteur qui peut devenir plus faible que la résistance Rs montée en série avec la diode laser.

La commande de la partie émissive nécessite que l'on prépolarise la partie diode laser $D_L$ en appliquant une tension et en injectant un courant au travers de la jonction pn de la partie active. En absence de rayonnement détecté, la diode Dd ne conduit pas (ne génère pas un courant).

En agissant sur les valeurs de résistances montées en série, et selon l'architecture de diodes considérées (tête bêche ou série), il est possible de réaliser des fonctions de déclenchement à seuil ou de bistabilité dans l'émission laser en fonction de l'éclairement.

Ce couplage de deux fonctions par croissance de matériaux semiconducteurs permet de réaliser un composant multi-fonctions sous forme de plaque ou l'une des faces est soumise à l'éclairement à détecter et l'autre émet un rayonnement dans le domaine spectral spécifique au matériau actif employé dans la jonction pn de la diode laser.

Le type d'intégration décrit précédemment n'est pas spécifique à l'emploi de détecteurs à multipuits quantiques. On peut envisager le même type d'intégration des deux fonctions en utilisant par exemple une hétéroépitaxie de matériaux II-VI ou d'autre III-V.

Par exemple, le dépôt de HgCdTe réalisé à partir de la méthode d'épitaxie par jets moléculaires sur GaAs permet d'intégrer également sur une des faces du substrat la fonction détection et sur l'autre face la fonction émission.

On a décrit un dispositif monolithique permettant de transposer un rayonnement situé dans un domaine spectral (rayonnement non visible par exemple) vers un autre. Le choix des matériaux déposés sur la structure à multipuits quantiques résonnante pour une longueur d'onde permettra de générer une onde optique dans un domaine spectral désiré.

Une face du dispositif reçoit le rayonnement à détecter, l'autre face émet une onde laser située dans le proche IR ou dans le visible. On peut concevoir ainsi des systèmes de type amplificateur de brillance pouvant être insérés dans des montages imageurs. Dans ce cas, l'emploi des matériaux III-V (en détection et en émission) a comme avantage de pouvoir réaliser des imageurs rapides (absence de rémanence ).

## Revendications

1. Convertisseur de fréquences lumineuses caractérisé en ce qu'il comporte :
   - un photo-détecteur à multipuits quantiques ou à super-réseau comportant un ensemble (5) de couches constituant le multipuits quantiques ou le super-réseau comprenant une première et une deuxième face, un rayonnement lumineux (W) à convertir étant reçu sur la première face et détecté par le photodétecteur ;
   - un dispositif laser (9) disposé sur la deuxième face du photodétecteur de façon à être connecté électriquement en série avec le photodétecteur.

2. Convertisseur de fréquences lumineuses caractérisé en ce que la première face comporte un réseau de couplage 2 du dispositif avec le rayonnement (W) à détecter.

3. Convertisseur de fréquences lumineuses selon la revendication 1, caractérisé en ce que le photodétecteur est solidaire par sa première face (10) à un substrat recevant par une face (10) un rayonnement à détecter et le transmettant au photodétecteur.

4. Convertisseur de fréquences lumineuses selon la revendication 3, caractérisé en ce que la face (10) du substrat recevant le rayonnement à détecter possède un réseau de couplage (2) du substrat au rayonnement à détecter.

5. Convertisseur de fréquences lumineuses selon la revendication 1, caractérisé en ce qu'il comporte une première couche de contact ohmique (4) associée à la première face ; une deuxième couche de contact ohmique associée à la deuxième face et au dispositif laser ; une troisième couche de contact ohmique associée à une quatrième face opposée à la troisième face du photodétecteur.

6. Convertisseur de fréquences lumineuses selon la revendication 5, caractérisé en ce qu'il comporte une première source de tension (30) connectée entre la première et la deuxième couche de contact ohmique et une deuxième source de tension (40) connectée entre la deuxième et la troisième couche de contact ohmique.

7. Convertisseur de fréquences lumineuses selon la revendication 1, caractérisé en ce que le photodétecteur est constitué de multipuits quantiques (5) et le dispositif laser est également constitué de multipuits quantiques.

8. Convertisseur de fréquences lumineuses selon la revendication 7, caractérisé en ce que le photodétecteur est constitué d'alternances de couches de GaAs et de $Ga_{1-x}$ Al As.

9. Convertisseur de fréquences lumineuses selon la revendication 7, caractérisé en ce que le dispositif laser est constitué d'alternances de couches de AlAs et de $Ga_{1-x}Al_xAs$.

FIG. 1

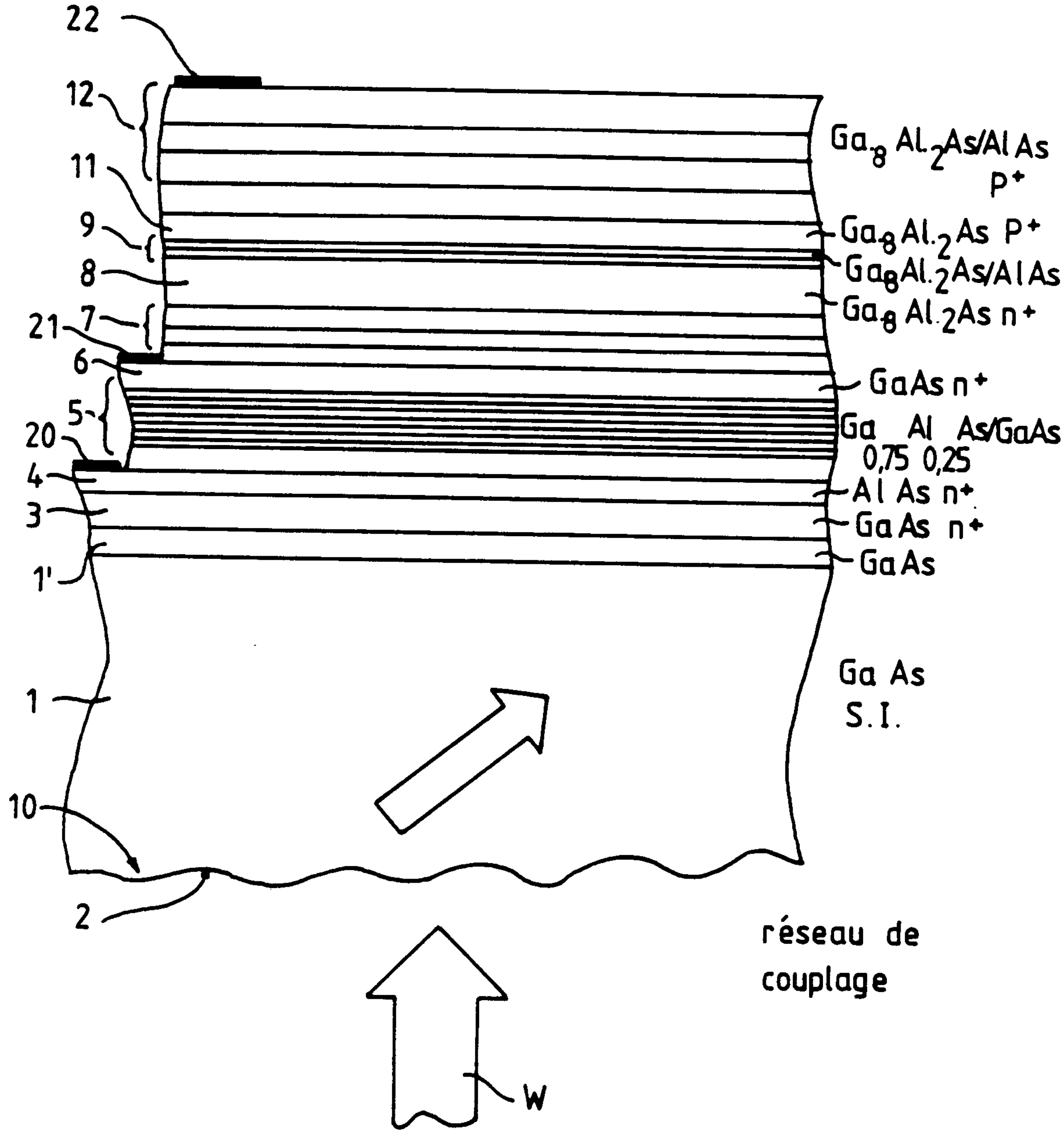
22
12
11
9
8
7
21
6
5
20
4
3
1'
1
10
2
W
Ga.8 Al.2As/Al As
P+
Ga8 Al.2As P+
Ga8Al.2As/AlAs
Ga8 Al.2As n+
GaAs n+
Ga Al As/GaAs
0,75 0,25
Al As n+
GaAs n+
GaAs
Ga As
S.I.
réseau de
couplage

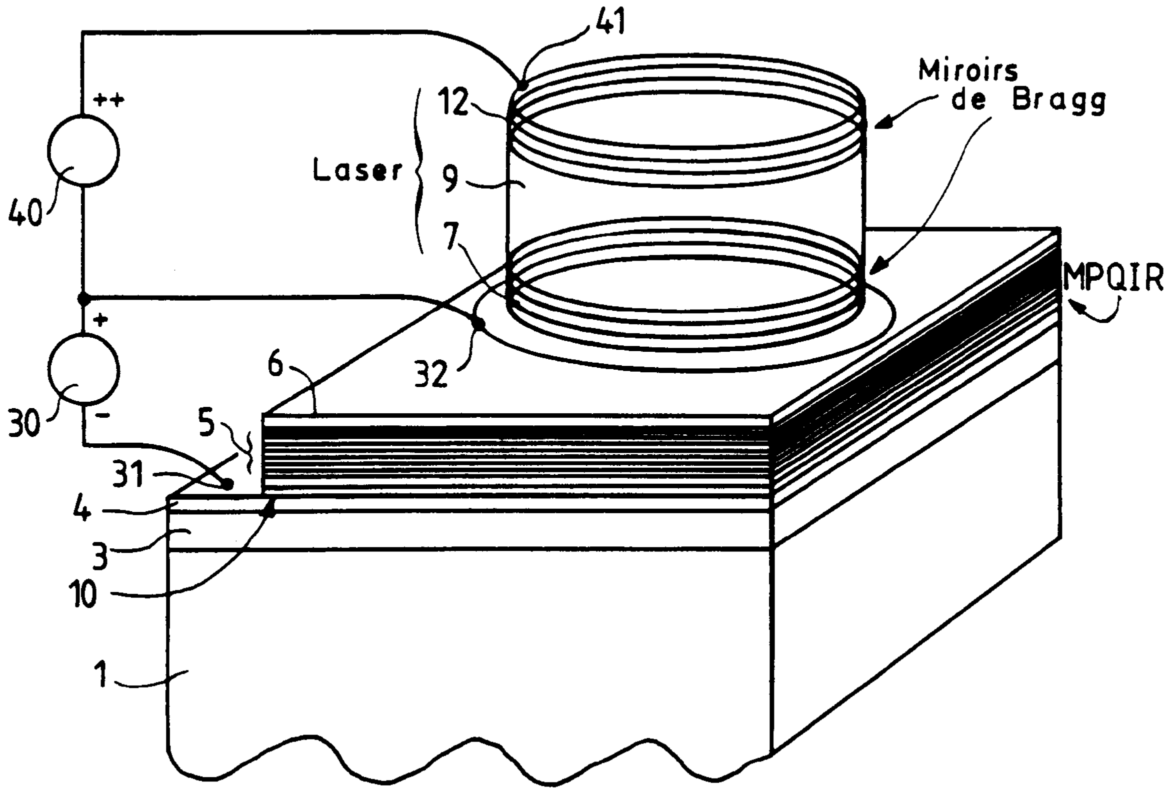
41
12
Miroirs
de Bragg
Laser
9
7
MPQIR
40
32
6
30
5
31
4
3
10
1

FIG.2

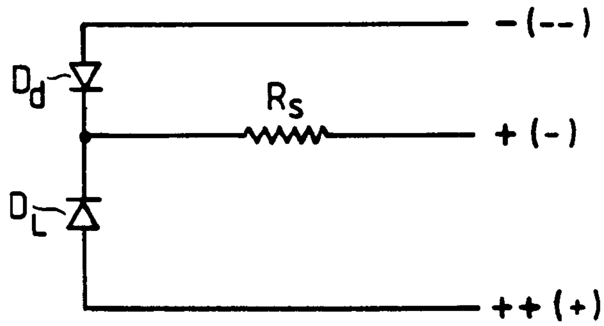
-(--)
$D_d$
$R_s$
+(-)
$D_L$
++(+)

FIG.3

Office européen des brevets

# RAPPORT DE RECHERCHE EUROPEENNE

Numero de la demande

EP 91 40 2465

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | PATENT ABSTRACTS OF JAPAN vol. 10, no. 347 (E-457)(2403) 21 Novembre 1986 & JP-A-61 150 285 ( NEC ) 8 Juillet 1986 * abrégé * | 1,3,5 | G02F2/02<br>H01S3/025<br>H01L31/153 |
| A | EP-A-0 323 073 (AT&T) * page 3, ligne 38 - page 4, ligne 1; figure 1 * | 1 | |
| A | DE-A-3 732 626 (SIEMENS) * colonne 2, ligne 37 - colonne 3, ligne 19; figure 1 * | 1 | |
| A | EP-A-0 164 604 (NEC) * page 3, ligne 11 - page 4, ligne 15; figure 1 * | 1 | |
| | | | **DOMAINES TECHNIQUES RECHERCHES (Int. Cl.5 )** |
| | | | G02F<br>H01S<br>H01L |

Le présent rapport a été établi pour toutes les revendications

| Lieu de la recherche | Date d'achèvement de la recherche | Examinateur |
|---|---|---|
| LA HAYE | 16 DECEMBRE 1991 | WONGEL H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)